(19) Europäisches Patentamt
European Patent Office
Office européen des brevets

(11) **EP 1 205 589 B1**

(12) **EUROPEAN PATENT SPECIFICATION**

(45) Date of publication and mention
of the grant of the patent:
**02.11.2011 Bulletin 2011/44**

(51) Int Cl.:
*D04B 1/00* (2006.01)          *D04B 1/14* (2006.01)
*D04B 1/24* (2006.01)          *H05K 9/00* (2006.01)
*A41B 17/00* (2006.01)

(21) Application number: **00929853.0**

(22) Date of filing: **24.05.2000**

(86) International application number:
**PCT/JP2000/003333**

(87) International publication number:
**WO 2000/071793 (30.11.2000 Gazette 2000/48)**

(54) **ELECTRO-MAGNETIC WAVE SHIELDING KNITTED MATERIAL AND ELECTRO-MAGNETIC WAVE SHIELDING CLOTHES**

ABSCHIRMUNGSGESTRICH UND ABSCHIRMUNGSKLEIDUNG GEGEN ELEKTOMAGNETISCHE WELLEN

MATIERE TRICOTEE DE BLINDAGE CONTRE LES ONDES ELECTROMAGNETIQUES ET VETEMENTS DE BLINDAGE CONTRE LES ONDES ELECTROMAGNETIQUES

(84) Designated Contracting States:
**DE FI FR GB SE**

(30) Priority: **24.05.1999   JP 14414399**
**25.05.1999   JP 14444599**
**02.11.1999   JP 31180599**

(43) Date of publication of application:
**15.05.2002   Bulletin 2002/20**

(73) Proprietor: **GUNZE LIMITED**
**Ayabe-shi,**
**Kyoto, 623-0011 (JP)**

(72) Inventors:
• **ISHIHARA, Ken**
**Shuso-gun,**
**Ehime 791-0504 (JP)**
• **NAMISAKI, Hisao,**
**Research & Development Dept.**
**Ayabe-shi,**
**Kyoto 623-0051 (JP)**
• **TANAKA, Yoshimi,**
**Research & Development Dept.**
**Ayabe-shi,**
**Kyoto 623-0051 (JP)**
• **MORITA, Shin-ichiro,**
**Research & Development Dept.**
**Ayabe-shi,**
**Kyoto 623-0051 (JP)**

• **HORI, Katsuhiro,**
**Research & Development Dept.**
**Ayabe-shi,**
**Kyoto 623-0051 (JP)**
• **ISHIKAWA, Kenzo,**
**Apparel Divisions Group**
**Miyazu-shi,**
**Kyoto 626-0043 (JP)**
• **YAMAZAKI, Takahiro,**
**Apparel Divisions Group**
**Miyazu-shi,**
**Kyoto 626-0043 (JP)**
• **SHIMIZU, Toshiyuki,**
**Apparel Divisions Group**
**Miyazu-shi,**
**Kyoto 626-0043 (JP)**

(74) Representative: **Müller-Boré & Partner**
**Patentanwälte**
**Grafinger Straße 2**
**81671 München (DE)**

(56) References cited:
EP-A- 0 615 012          WO-A1-89/12706
JP-A- 7 166 470          JP-A- 8 500 896
JP-U- 2 111 361          JP-U- 3 055 556
JP-Y2- 4 054 165          US-A- 5 073 984

**Description**

The present invention relates to an electromagnetic wave shielding knitted material and an electromagnetic wave shielding garment, which protect the human body from the influence of electromagnetic waves leaked from cellular telephones, microwave ovens, CRTs of televisions and personal computers or other electronic equipment that generates electromagnetic waves, and electromagnetic fields radiated from antennas of cellular telephones, radio equipment and like equipment placed in the vicinity of the human body. The electromagnetic wave shielding knitted material and electromagnetic wave shielding garment according to the present invention not only protect the human body from the influence of electromagnetic waves, but also effectively prevent electromagnetic waves from causing malfunction of medical devices implanted in the body, such as pacemakers.

As a conventional measure to prevent damages by electromagnetic waves emitted from an electromagnetic source, a metal net or like electromagnetic wave blocking layer is wrapped around the electromagnetic source to prevent leakage of electromagnetic waves. However, with the recent development of electronic equipment, electromagnetic sources greatly increase in number and become more and more miniaturized. Accordingly, attempts have been made to provide an electromagnetic source with an electromagnetic wave shielding net (layer) to prevent leakage of electromagnetic waves. For this purpose, Japanese Unexamined Patent Publication No. 1998-168702, Japanese Utility Model No. 3010147, Japanese Unexamined Patent Publication No. 1996-176962 and Japanese Unexamined Patent Publication No. 1998-292252 disclose knitted or woven electromagnetic wave shielding nets (knitted or woven fabrics) made of lightweight, flexible conductive fibers developed for use as an electromagnetic wave blocking film or as an equipment's built-in electromagnetic wave shielding net.

However, the disclosed techniques are not capable of completely shielding electromagnetic wave sources. Moreover, electromagnetic wave emission is essential in some equipment, such as radio equipment. Therefore, shielding measures only on electromagnetic wave sources are clearly insufficient.

Thus, there is a necessity for an electromagnetic wave shielding measure with a garment for the human body. Electromagnetic wave shielding garments should have comfortable wearability as well as high electromagnetic wave attenuation efficiency. Some electromagnetic wave shielding garments have been proposed which consist merely of conductive fibers, but these garments are poor in softness, drapability, bulkiness, compression characteristics and like characteristics that determine so-called "hand". Thus, these garments are not only unsatisfactory in basic requirements such as sweat absorbency, but also liable to cause skin disorders (allergies) due to metals contained in conductive fibers. Accordingly, a measures to solve these problems has been strongly desired.

Japanese Unexamined Patent Publication No. 1998-77507 proposes a garment comprising a natural or chemical fiber knitted or woven together with a conductive fiber.

Further, Japanese Unexamined Patent Publication No. 1999-50352 proposes a fabric having both electromagnetic wave shielding capability and metal allergy resistance, the fabric being obtained by covering a conductive fiber as stuffing thread with a nonconductive fiber so that the conductive fiber is out of direct contact with the skin.

However, although the garment disclosed in Japanese Unexamined Patent Publication No. 1998-77507 is reduced in the amount of direct contact of the conductive fiber with the skin, the conductive fiber still partially comes into direct contact with the skin. Accordingly, the garment is unsatisfactory in view of its unpleasant wearing feeling and metal allergy resistance. On the other hand, the fabric disclosed in Japanese Unexamined Patent Publication No. 1999-50352 is free from the above problems since the conductive fiber used therein does not come into direct contact with the skin. However, there is a further demand for decreasing the amount of conductive fiber to be used for reducing the cost, since conductive fibers are generally extremely expensive.

Japanese Examined Utility Model Publication No. 1992-54165 discloses an undergarment which is always wearable, obtained by sewing a knitted or woven fabric laminate comprising a knitted or woven fabric made of a conductive fiber and a knitted or woven fabric made of a highly hygroscopic fiber for normal clothes, in such a manner that the highly hygroscopic fabric comes inside the undergarment. However, the publication nowhere discloses specific means for imparting an effective electromagnetic wave shielding capability to the knitted or woven fabrics.

Conventionally, in specifications of electromagnetic wave shielding garments, electromagnetic shielding properties of an electromagnetic wave shielding garment comprising a conductive fiber yarn were measured using a material piece of the garment, by widely known KEC method, Advantest method or like method using an apparatus for measuring and evaluating electromagnetic wave shielding properties, in order to prevent the influence of electromagnetic waves on the human body and on medical equipment implanted in the human body.

However, even if the material piece has a desired electromagnetic wave shielding capability, the garment sometimes does not have the desired electromagnetic wave shielding capability, due to diffraction, infiltration, etc. of electromagnetic waves, depending on the garment shape.

The present invention has been accomplished in view of the above situation. An object of the present invention is to provide a material for clothes which gives no unpleasant feeling when being put on, causes no skin disorder due to metal allergy, and contains less amount of conductive fiber while maintaining electromagnetic wave shielding capability, so as to achieve reduction in cost.

A further object of the present invention is to provide an electromagnetic shielding garment free of influence of diffraction, infiltration, etc. of electromagnetic waves, the garment being obtainable by measuring electromagnetic shielding capability as a garment, and designing and making a garment shape to achieve a desired electromagnetic wave shielding capability.

Fig. 1 is a graph showing the relation between cotton count and shielding capability in Reference Example 1.

Fig. 2 is a graph showing the relation between cotton count and G-soft in Reference Example 1.

Fig. 3 is a graph showing the relation between cotton count and shielding capability in Reference Example 2.

Fig. 4 is a graph showing the relation between cotton count and G-soft in Reference Example 2.

Fig. 5 is a front view of an embodiment of the electromagnetic wave shielding knitted material of the present invention.

Fig. 6 is a graph showing the relation between electromagnetic wave shielding capability and cost.

Fig. 7 is a diagram of a measurement system for an apparatus for measuring and evaluating electromagnetic wave shielding properties as a garment.

Fig. 8 shows the result of electromagnetic field distribution analysis of the short-sleeved, round-necked undershirt model obtained in Example 5.

Fig. 9 shows the result of electromagnetic field distribution analysis of the short-sleeved, V-necked undershirt model obtained in Example 6.

Fig. 10 shows the result of electromagnetic field distribution analysis of the collard shirt type garment model obtained in Comparative Example 3.

Fig. 11 shows the result of electromagnetic field distribution analysis of the vest type garment model obtained in Comparative Example 4.

Fig. 12 shows the result of electromagnetic field distribution analysis of the dummy of the human body without an electromagnetic wave shielding garment in Comparative Example 5.

The present invention provides the following electromagnetic wave shielding knitted materials and electromagnetic wave shielding garments.

1. A reversible electromagnetic wave shielding knitted material comprising a conductive fiber yarn and an elastic fiber yarn interknitted with each other as a surface side and a natural fiber yarn as a back side, wherein the proportion of the elastic fiber yarn is greater than 0 but not greater than 2/3 of the total amount of the conductive fiber yarn and the elastic fiber yarn interknitted with each other.

2. A material according to item 1, which comprises a plain knitted structure or rib knitted structure obtained by plating the conductive fiber yarn and the natural fiber yarn in all the courses of the knitted material.

3. A material according to item 1, wherein the conductive fiber yarn is a multifilament in which each filament comprises a nylon fiber, a polyester fiber, an acrylic fiber, a polypropylene fiber or like synthetic fiber having a denier (d) of about 2 to about 8, and a metal component applied to a surface of the synthetic fiber by sputtering, vacuum deposition, electroless plating or like method.

4. A material according to item 1, wherein the conductive fiber yarn is a fiber of polyacetylene or like conductive resin, or a fine wire of gold, silver, copper, stainless steel or like metal.

5. A material according to item 1, wherein the natural fiber yarn comprises a natural fiber, a natural fiber/rayon fiber mixed spun yarn, or a natural fiber/ synthetic fiber mixed spun yarn.

6. A material according to item 1, wherein the conductive fiber yarn is a silver-plated nylon yarn having a denier (d) of about 70 to about 210, and the natural fiber yarn is a cotton yarn having a count of 30 to 150, the material having a KES hand value (G-soft) of at least 6 and an electromagnetic wave shielding capability of at least 20 dB.

7. A material according to item 1, wherein the elastic fiber yarn is a single-covered yarn or a double-covered yarn comprising a polyurethane thread as a stuffing thread covered with a nylon thread.

8. A material according to item 1, wherein the elastic fiber yarn has a denier (d) of about 10 to about 200.

9. A material according to item 1, which is used as an undergarment.

10. An electromagnetic wave shielding garment according to item 1, which prevents electromagnetic waves from causing cardiac pacemaker malfunction.

Not within the scope of the present invention is an electromagnetic wave shielding garment obtainable by: measuring electromagnetic wave shielding capability as a garment using an apparatus for measuring and evaluating electromagnetic wave shielding capability comprising a measurement system in the shape of the upper part of the human body for measuring electromagnetic wave shielding capability as a garment in the state of being worn by the human body; designing a garment shape to obtain a desired electromagnetic wave shielding capability; and making a garment of the designed shape.

An electromagnetic wave shielding garment according to the item above, wherein the apparatus for measuring and evaluating electromagnetic wave shielding capability comprises: a signal transmitter for emitting a high-frequency signal; a transmission antenna connected to the high-frequency signal transmitter for radiating a high-frequency electromagnetic field into a free space; a dummy which is similar to the human body in shape and electric constants including dielectric constant and magnetic permeability; a receiving antenna provided at a predetermined position within the dummy for receiving the high-frequency electromagnetic field, the receiving antenna being equivalent in impedance to the human body and similar in shape to a lead wire of a device surgically implantable in the human body; and a signal receiver connected to the receiving antenna for receiving the high-frequency signal.

A garment according to the item above, which has an electromagnetic wave shielding capability as a garment of at least 15 dB when the distance between the transmission antenna and the surface of the dummy is 5 cm, at least 18 dB when the distance is 10 cm, and at least 20 dB when the distance is 20 cm, relative to the amount of electromagnetic waves received by the dummy without the garment.

An electromagnetic wave shielding garment according to the item above, which has such a shape that forms no gap when worn.

An electromagnetic wave shielding garment according to the item above, wherein the shape that forms no gap is an undergarment or a T-shirt.

Since the knitted material of the present invention is used as a garment (in particular, an undergarment), the material has a reversible structure in which the side close to the skin comprises a natural fiber yarn. To obtain such a structure, a conductive fiber and a clothing fiber are fed to a plain knitting machine or a rib knitting machine in such a manner that the conductive fiber is covered with the clothing fiber. For example, plating of a conductive fiber yarn and a natural fiber yarn is carried out in all the courses so that the natural fiber yarn comes to the side close to the skin.

Examples of conductive fiber yarns for use in the invention include yarns made of fibers of polyacetylene or like conductive resin; yarns obtained by applying polyacetylene or like conductive resin to a synthetic fiber such as nylon, polyester, acrylic or polypropylene; yarns obtained by applying gold, silver, copper, nickel or like metal component by vacuum deposition, sputtering, electroless plating or like method; and fine wires of stainless steel, gold, silver, copper or like metal. Particularly preferred are yarns obtained by electrolessly plating a synthetic fiber with silver.

Specific examples of conductive fiber yarns include X-Static (tradename of Sauquit) comprising a nylon multifilament plated with silver.

Preferably, each filament of the conductive fiber yarn has a denier (d) of about 2 to about 8, and the conductive fiber yarn has a denier (d) of about 70 to about 210.

Examples of natural fiber yarns include yarns of cotton, silk, hemp or the like; and yarns of rayon, Lyocel, Tencel or like regenerated fiber; yarns of acetate, diacetate or like semi-synthetic fiber; and yarns of acrylate, modified nylon or like hygroscopic synthetic fiber with satisfactory comfortableness as an undergarment. The natural yarn for use in the invention is not limited to the above examples, and include rayon staple fiber spun yarns, natural fiber and rayon fiber mixed spun yarns, and natural fiber and synthetic fiber mixed spun yarns. Using any of these yarns, a knitted garment (in particular, an undergarment) which can prevent the body from the electromagnetic wave damages and have good wearing feeling and hand.

The electromagnetic wave shielding knitted material of the invention has higher hand (has a higher G-SOFT value) when using a natural fiber yarn with a higher fineness. On the other hand, the material has a higher electromagnetic wave shielding capability when using a conductive fiber yarn with a lower fineness. However, the fineness of the two types of yarns should be well-balanced, since a great difference in fineness results in unstable knitting operation.

Considering the hand, electromagnetic wave shielding capability and balance in fineness, the natural fiber yarn, when made of cotton, has a cotton count of 30 to 150, preferably 30 to 90, more preferably 40 to 70.
The conductive fiber yarn, when being a silver-plated nylon yarn, has a denier (d) of 70 to 210, preferably 70 to 150, more preferably 80 to 120.

Since conductive fiber yarns are generally very expensive, the conductive fiber yarn side of the material of the invention further comprises an elastic fiber yarn interknitted with the conductive fiber yarn, in order to decrease the amount of the conductive fiber yarn and thereby reduce the cost. A preferred elastic fiber yarn is a single-covered or double-covered yarn comprising a polyurethane thread as a stuffing thread covered with a nylon thread. However, any yarns having properties equivalent to the single- or double-covered yarn are usable.

As to the fineness of the elastic fiber yarn, an elastic fiber yarn with a denier (d) less than about 10 is not preferable, since use of such an elastic fiber yarn forms large spaces between the conductive fiber yarns due to insufficient elasticity, resulting in a lowered electromagnetic wave shielding capability. On the other hand, an elastic fiber yarn with a denier (d) of greater than about 200 is also undesirable, since the elastic fiber yarn is too thick and forms large spaces between the conductive fiber yarns, resulting in a lowered electromagnetic wave shielding capability. Therefore, the elastic fiber yarn preferably has a denier (d) of about 10 to about 200, more preferably about 70 to about 200.

The proportion of the elastic fiber yarn is greater than 0 but not greater than 2/3, preferably greater than 1/3 but not greater than 1/2 of the total amount of the conductive fiber yarn and the elastic fiber yarn interknitted with each other.

The electromagnetic wave shielding knitted material of the invention is suitable for shirts, briefs, knit trunks and other undergarments, T-shirts and like clothes.

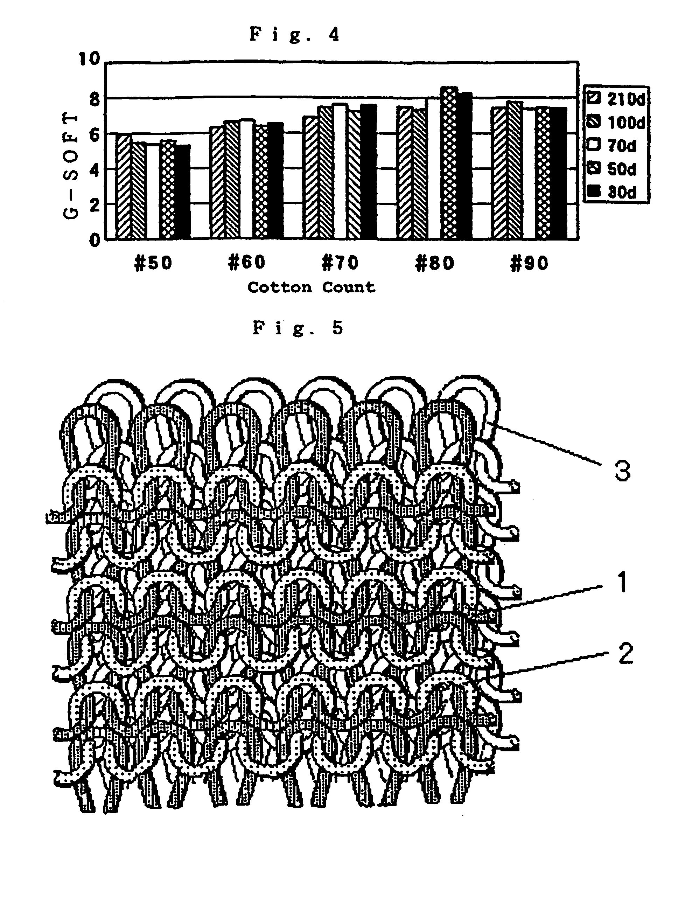

Fig. 5 shows an embodiment of the electromagnetic wave shielding knitted material of the present invention. In Fig. 5, 1 and 2 indicate a conductive fiber yarn and an elastic fiber yarn, respectively. These yarns are interknitted at a ratio of 1:1 (the proportion of the elastic fiber yarn being 1/2) to form a front side of the knitted material. 3 indicates a natural fiber yarn which is knitted to form a back side (the side close to the skin) of the knitted material. Thus, the knitted material of this embodiment is knitted as a reversible plain knitted fabric. However, the knitted material of the invention is not limited to the reversible plain knitted fabric, but may have any knit structure as long as it has a reversible form.

The electromagnetic wave shielding garment of the invention is designed using an apparatus for measuring and evaluating electromagnetic wave shielding capability comprising a measurement system in the shape of the upper part of the human body in order to maintain the state of a garment as worn on the human body. The apparatus comprises, for example: a signal transmitter for transmitting a high-frequency signal; a transmission antenna connected to the high-frequency signal transmitter for radiating a high-frequency electromagnetic field into a free space; a dummy having a shape and electric constants (dielectric constant, magnetic permeability, etc.) approximately equal to the human body; a receiving antenna provided at a predetermined position within the dummy for receiving the high-frequency electromagnetic field, the receiving antenna being equivalent in impedance to the human body and a approximately similar in shape to a lead wire of a device surgically implantable in the human body; and a signal receiver connected to the receiving antenna for receiving the high-frequency signal.

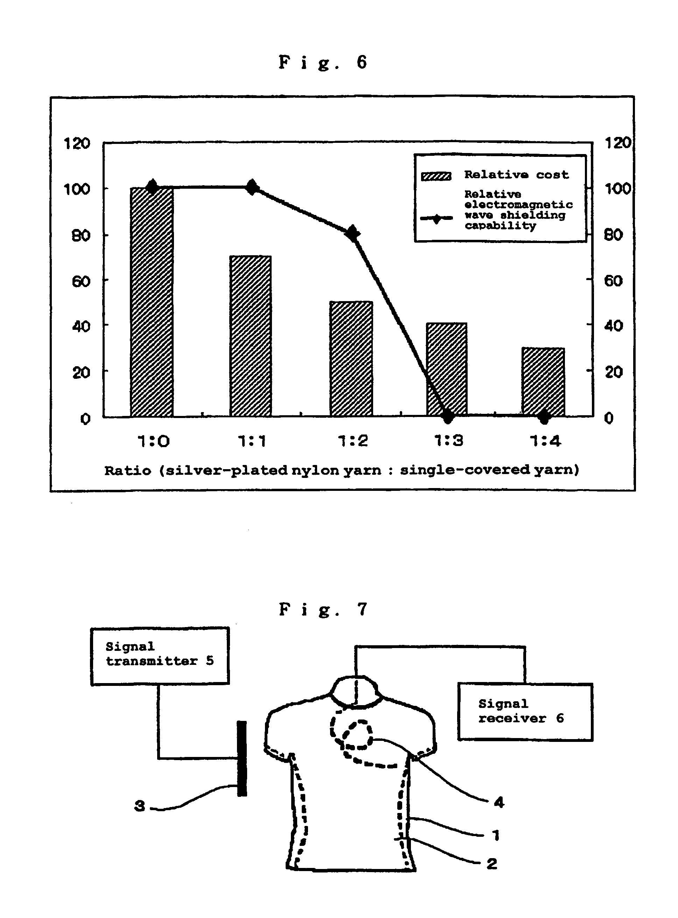

Fig. 7 shows an embodiment of the measurement system of the apparatus for measuring and evaluating electromagnetic wave shielding capability. An electromagnetic wave shielding garment 1 is put on a dummy of the human body 2. High-frequency electric power with a predetermined frequency band is applied from the direction of a transmission antenna 3, and high frequency electric power that has passed through the shielding garment 1 is received by a receiving antenna 4 provided at a predetermined position within the dummy 2, thereby measuring the electromagnetic wave shielding capability of the shielding garment 1. A signal transmitter 5 is used to apply high-frequency electric power to the transmission antenna 3, and a signal receiver 6 is used to detect high-frequency electric power that has passed through the shielding garment 1 from the receiving antenna 4. As the signal transmitter 5 and the signal receiver 6, a network analyzer or like means serving as both the transmitter and the receiver may be used to output high-frequency electric power with an automatically scanned frequency and detect high-frequency electric power. The dummy 2 is a container molded of FRP (specific dielectric constant 3) filled with a 0.5% NaCl solution which is widely used as a solution equivalent in dielectric constant and other electric constants to the living body. Although this embodiment employs an FRP-molded container and a 0.5% NaCl solution, it is also possible to employ a generally used phantom having a dielectric constant and magnetic permeability equivalent to those of the human body or like living body. In short, any dummy may be utilized as long as it has a shape and electric constants (such as dielectric constant and magnetic permeability) approximately equal to those of the human body and has a structure that permits setting of the receiving antenna 4 at a predetermined position within the dummy. The receiving antenna 4 is an imitation of a lead wire of a cardiac pacemaker, i.e., an implantable device in which the influence of antennas of cellular telephones, radio equipment or like equipment placed in the vicinity of the human body may cause serious trouble. The receiving antenna 4 comprises a coaxial cable and a load resistor (500 Ù) connected at the end of the coaxial cable to attain an impedance equivalent to that of the human body. The coaxial cable preferably has a shape similar to a lead wire of a cardiac pacemaker implanted within the human body. Although this embodiment employs a coaxial cable and a load resistor, it is of course possible to use a cardiac pacemaker lead wire as such. That is to say, any structure can be used as long as it is equivalent in impedance to the human body and similar in shape to a device implantable within the human body. In this embodiment, a cardiac pacemaker is assumed as the implantable to be protected from electromagnetic waves, but the apparatus can be applied to measure capability of shielding other types of implantable devices from electromagnetic waves, by properly constructing the receiving antenna 4.

With the apparatus, an electromagnetic wave shielding garment can be put on the dummy to measure capability of shielding electromagnetic waves propagated from a desired position, angle and distance. Using the apparatus, it is possible to design a garment shape to obtain a desired electromagnetic wave shielding capability without the influence of diffraction, infiltration, etc. of electromagnetic waves, and make a garment of the designed shape. The process for designing the garment shape usually comprises: propagating electromagnetic waves from a desired position, angle and distance to measure the electromagnetic wave amount received by the dummy of the human body wearing the garment and the amount received by the dummy without the garment; and determining the material and shapes of the neck, sleeves, overlapping portion on the body of the electromagnetic wave shielding garment so that the garment has, under the same electromagnetic wave propagation conditions, an electromagnetic wave shielding capability of at least 10 dB, preferably at least 15 dB, more preferably at least 15 dB when the distance between the transmission antenna and the surface of the dummy is 5 cm, and at least 18 dB when the distance is 10 cm, and at least 20 dB when the distance is 20 cm.

The electromagnetic wave shielding garment of the invention is made from the electromagnetic wave shielding knitted material of the invention.

The electromagnetic wave shielding garment of the invention can be obtained by cutting and sewing a fabric having, as the fabric itself, excellent capability of shielding electromagnetic fields in the vicinity as described above. When making the garment, parts constituting the garment are preferably sewn so that the conductive fiber yarn-containing surfaces of the parts are brought into contact with each other to provide conduction. More preferably, the conductive fiber yarn-containing surfaces of the parts are brought into contact with each other and then sewn together with conductive thread. As to the garment shape, a garment having a front button closure or like overlapping portion on the body, such as a collared shirt, is not desirable since, when wearing the garment, gaps are formed at the overlapping portion and allow electromagnetic waves to infiltrate. Also undesirable is a garment in which a conductive material covers only part of the human body, such as an apron for covering only the front side of the human body, since electromagnetic waves diffuse inside the garment around the edge of the conductive material.

Thus, the electromagnetic wave shielding garment has a shape that can achieve a desired electromagnetic wave shielding capability without the influence of diffraction, infiltration, etc. of electromagnetic waves, the shape being obtained by measurement with an apparatus for measuring and evaluating electromagnetic wave shielding capability as a garment. Preferable is a garment for the upper part of the body, in which the whole surface contains a conductive material, and which has no overlapping portion, or has an overlapping portion that does not impair the conductivity nor does form gaps when the wearing the garment.

More preferred is a short-sleeved or long-sleeved undergarment or T-shirt, or a collared shirt having, at the overlapping portion on the body, a fastener made only of conductive materials. Most preferable is a round-necked or high-necked garment with long or short sleeves with fastened cuffs, since such a garment can prevent infiltration of electromagnetic waves from the cuffs and neck openings.

The following examples are provided to illustrate the present invention in further detail, and are not to limit the scope of the claims of the invention. In the Examples, materials and garments are evaluated by the following methods:

(1) Electromagnetic wave shielding capability as a material (KEC method)

A material (20 cm x 20 cm) to be tested was held between a transmission antenna and a receiving antenna installed within a short distance of each other in a shield box (MB8602B; a product of Anritsu). Electromagnetic waves of different frequencies ranging from 100 MHz to 1 GHz were transmitted, and the attenuation at each frequency was measured using a spectrum analyzer (TR4173; Advantest). The shielding capability was evaluated by the difference (dB) between the measurements with and without the material held between the antennas, at a frequency band for cellular telephones (800 MHz).

(2) Electromagnetic wave shielding capability as a garment

In an electric wave darkroom, the electromagnetic wave shielding capability as a garment was measured, using the measurement system shown in Fig. 7. Specifically stated, high-frequency electric power (800 MHz) was transmitted from a signal transmitter 5 (R3551; Advantest) via a transmission antenna 3 (dipole antenna TR1722; Advantest) installed at a predetermined position, angle and distance, toward a dummy 2 (a human-shaped container molded of FRP with a specific dielectric constant of 3 and filled with a 0.5% NaCl solution widely known as a solution equivalent to the living body in electric constants such as dielectric constant). The dummy 2 was provided, at a predetermined position therein, with a receiving antenna 4 (an antenna comprising a coaxial cable and a 500 Ù load resistor connected at the end of the coaxial cable to attain an impedance equivalent to that of the living body, the coaxial cable being similar in shape to a lead wire of a cardiac pacemaker implantable in the human body). The attenuation of transmitted electric power was measured with and without putting an electromagnetic wave shielding garment 1 on the dummy 2, using a signal receiver 6 (spectrum analyzer R3361A; Advantest). As to the position, angle and distance of the transmission antenna 3, the antenna 3 was placed in front of the dummy 2, at the same height as the receiving antenna 4, at such an angle that the element is in the horizontal position, and at a distance of 5 cm, 10 cm or 20 cm from the dummy 2. These conditions produced most significant differences in electromagnetic wave shielding capability as a garment. The shielding capability was evaluated by the difference (dB) between the measurements with and without the electromagnetic wave shielding garment on the dummy.

(3) Electromagnetic field distribution analysis by FDTD method

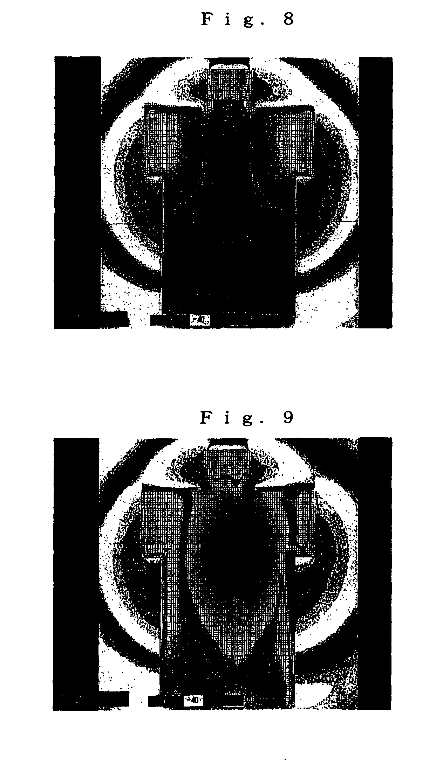

Using an FDTD analysis simulator (XFDTD 5.0 Bio-Pro; REMCOM), a dummy having a 300 mm x 100 mm x 500 mm body with a conductivity of 1.43 and a specific dielectric constant of 53, a neck and arms was defined in a free space (600 mm x 400 mm x 700 mm) divided into 10 mm x 10 mm x 10 mm cubes. Then, a 800 MHz sine wave was radiated from a half-wavelength dipole antenna horizontally placed 50 mm ahead of the dummy, to determine magnetic field intensity distribution (Hz components, XZ section) about 10 ns after reaching a steady state at a depth of 15 mm from the body surface of the dummy (the depth at which a pacemaker is implanted). Models of the shielding garments shown in Table 2 were used as analysis models. The models had a conductivity of $6 = 1 \times 10^5$ S/m, which is similar to the conductivity of the shielding garments, and were put on the dummy with a 5 mm gap between the model and the dummy. The evaluation was carried out based on the color of the chest portion in the analysis results (Figs. 8 to 12). The magnetic field intensities indicated by the colors is greater in the order of: red>orange>yellow>green>blue. Thus, warm colors indicate a great amount of electromagnetic waves.

(4) G-soft evaluation test method:

This test was carried out according to "Standardization and Analysis of Evaluation of Hand" (second edition, Sueo Kawabata, Journal of the Textile Machinery Society of Japan, July 10, 1980).

KES mechanical properties are defined as follows.

1: LT Linearity of tension
2: WT Tensile energy per unit area
3: RT Tensile resilience
4: B Bending rigidity per unit length
5: 2HB Hysteresis
6: G Shear rigidity
7: 2HG Hysteresis at a shear angle of 0.5°
8: LC Linearity of compression properties
9: WC Compression energy
10: RC Compression resilience
11: MIU Mean coefficient of friction
12: MMD Mean deviation of coefficient of friction
13: SMD Mean deviation of surface roughness
14: T Thickness at a pressure of 0.5 Kgf/cm
15: W Weight per unit area

The equation to be used in the calculation is as follows:

$$\text{G-soft} = C_0 + \sum_{j=1}^{15} C_j \cdot (X_j - X_j (AV))/\sigma_j \qquad (1)$$

Here, $C_0$ is a constant (=6.253), and $C_j$, $X_j$ (AV) and $\sigma_j$ are coefficients shown in Table 1.

(2) KEC electromagnetic wave shielding capacity evaluation test method:

This test was carried out based on "Science of Textile Consumption", Vol. 40, No. 2 (1999), pp. 100-108, Society of Science of Textile Consumption of Japan.

Reference Example 1

Used were silver-plated nylon multifilament yarns ("X-static" manufactured by Sauquit) of a variety of deniers as conductive fibers, and cotton yarns of variety of counts. The two types of yarns were aligned and fed to a 24.5 gauge plain knitting machine to carry out plating in all the courses, to prepare knitted materials with a reversible structure comprising a surface layer made of a cotton yarn and a back layer made of a conductive fiber yarn, the two layers being integrally laminated.

Using the knitted materials, undergarments were sewn which had the cotton yarn knit layer on the inside and the conductive fiber knit layer on the outside.

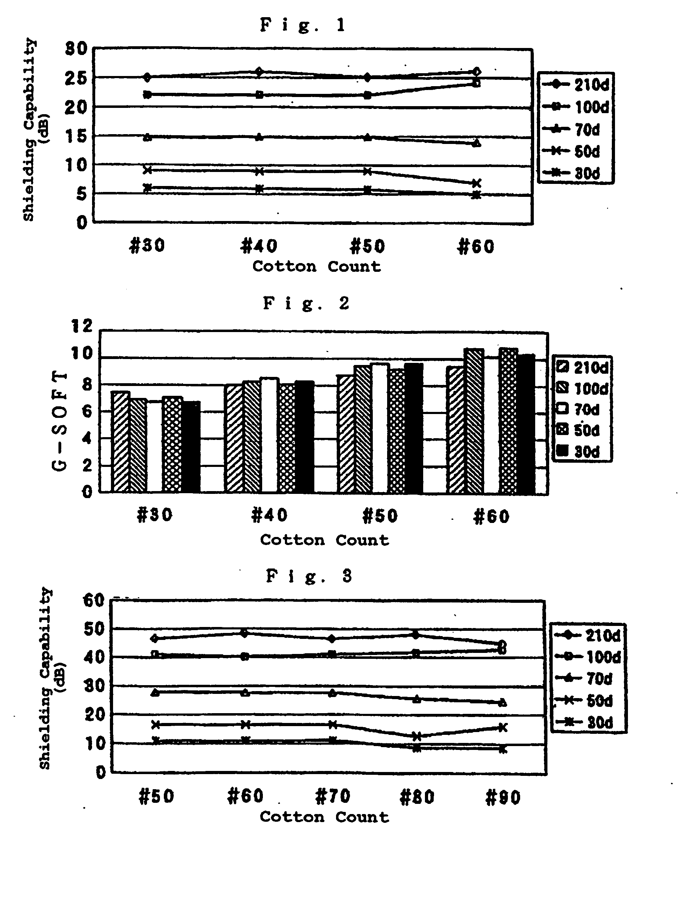

Fig. 1 shows the components and performance evaluation results (hand evaluation value of the knitted materials: G-soft; electromagnetic wave shielding capability (dB) measured by KEC method at 800 MHz). The figure reveals that the reversible knitted materials with a 24.5 gauge plain knit structure had a necessary electromagnetic wave shielding capability (20 dB) regardless of the count of the cotton yarn used, when a conductive fiber yarn having a denier of at least 100d/34f was used. The denier of the conductive fiber yarn greatly influences the electromagnetic wave shielding capability.

On the other hand, as shown in Fig. 2, the knitted materials had satisfactory hand for practical use regardless of the denier of the conductive fiber yarn, but the count of the cotton yarn influenced the hand of the knitted materials. Specifically, the greater the cotton count was, the softer the hand became.

Further, wearing tests of the trial products of the undergarments revealed that the trial products had good hand without problems for practical use, had sufficient sweat absorbency, and caused no metal allergy.

Reference Example 2

Using the same conductive fiber yarns and cotton yarns as in Reference Example 1, the knitting operation of Reference Example 1 was repeated except that the knit structure was changed to 18.6 gauge rib knitting. Thus, the two types of yarns were aligned and fed to a rib knitting machine to carry out plating in all the courses, to prepare reversible knitted materials comprising a surface layer made of a cotton yarn and a back layer made of a conductive fiber yarn. Using this knitted materials, shirts (undergarments) for wearing tests were sewn in the same manner as in Reference Example 1. Further, performance evaluation was carried out in the same manner as in Reference Example 1.

Fig. 3 shows the evaluation results, which were similar to the evaluation results obtained in Reference Example 1. Fig. 3 also reveals that, when the conductive fiber knit yarn layer is made by rib knitting, it is necessary to use a conductive fiber yarn of at least 70d/34f to achieve a required electromagnetic wave shielding capability (20 dB). Thus, the denier of the conductive fiber yarn required to obtain a necessary shielding capability in this Example is lower than in Reference Example 1.

Other performance evaluation showed similar results to the results obtained in Reference Example 1, as presented in Fig. 4.

With the above structure, electromagnetic wave shielding knitted materials have good KES hand evaluation value (G-Soft) of greater than 6 and a high sweat absorbency, and enables provision of always wearable knit undergarments that protect the human body from electromagnetic wave damage with high productivity.

Further, using the reversible knitted materials , garments can be prepared in which a conductive fiber is covered by a clothing fiber, so that the conductive fiber does not come into direct contact with the skin and causes no skin disorder owing to metal allergy.

Table 1

| j= | | Basic mechanical properties of fabric | Unit | Cj | Xj (AV) | δj |
|---|---|---|---|---|---|---|
| 1 | LT | Linearity of tension | Dimensionless | -0,4202 | 0.7756 | 0.0679 |
| 2 | WT | Tensile energy per unit area | gf·cm/cm$^2$ | -0.0401 | 0.6808 | /0.2557 |
| 3 | RT | Tensile resilience | % | -0.0443 | 1.5952 | 0.0639 |
| 4 | B | Bending rigidity per unit length gf· per unit length | cm$^2$/cm | -1.4418 | -1.7851 | 0.3288 |
| 5 | 2HB | Hysteresis | gf·cm/cm | 0.1699 | -1.6590 | 0.3213 |
| 6 | G | Shear rigidity | gf/cm·deg | 0.0251 | -0.4000 | 0.1276 |
| 7 | 2HG | Hysteresis at a shear angle of 0.5° | gf/cm | -0.1357 | 0.0444 | 0.1486 |
| 8 | LC | Linearity of compression properties | Dimessionless | -0.0005 | 0.6337 | 0.0692 |
| 9 | WC | Compression energy | gf · cm/cm$^2$ | 0.5584 | -0.9937 | 0.1526 |
| 10 | RC | Compression resilience | % | 0.3396 | 38.1224 | 5.6815 |
| 11 | MIU | Mean coefficient of friction | Dimensionless | -0,2220 | -0.5952 | 0.0861 |
| 12 | MMD | Mean deviation of coefficient of friction | Dimensionless | -0.0867 | -1.5999 | 0.2018 |
| 13 | SMD | Mean deviation of surface roughness | μm | -0.1525 | 0.9280 | 0.1999 |
| 14 | T | Thickness at a pressure of 0.5 Kgf/cm | Mm | -0.2283 | 0.0638 | 0.1361 |
| 15 | W | Weight per unit area | mg/cm$^2$ | 0.3016 | 17.3383 | 5.0040 |

Example 3

Used were a 200 d silver-plated nylon yarn ("X-STATIC" manufactured by SAUQUIT) as a conductive fiber yarn, a single-covered yarn comprising a 20 d polyurethane stuffing thread covered with a 30 d nylon thread as an elastic fiber yarn, and a No. 30 count cotton yarn as a natural fiber yarn. The yarns were knitted to prepare a reversible plain knitted material of the present invention, which comprised a surface side made of the silver-plated nylon yarn and the single-covered yarn interknitted at a ratio of 1:1 (the proportion of the single-covered yarn being 1/2) and a back side (the side that would come into contact with the skin) made of the cotton yarn. The obtained material was cut and sewn in a routine manner to obtain an undergarment. Fig. 6 shows the relation between electromagnetic wave shielding capability and cost of the undergarment. The electromagnetic wave shielding capability is expressed in a value relative to a reference sample, based on the magnetic field shielding ratio at 800 MHz measured according to the KEC (Kansai Electronic Industry Development Center) method. The cost is also expressed in a value relative to the reference sample. The reference sample was an undergarment prepared in the same manner as above except that the surface side was made by interknitting the silver-plated nylon yarn and the single-covered yarn at a ratio of 1:0 (the proportion of the single-covered yarn being 0).

Example 4

An undergarment was prepared by following the procedure of Example 3 except that the silver-plated nylon yarn and the single-covered yarn were interknitted at a ratio of 1:2 (the proportion of the single-covered yarn being 2/3). The results are shown in Fig. 6 in the same manner as the results of Example 3.

(Comparative Example 1)

An undergarment was prepared by following the procedure of Example 3, except that the silver-plated nylon yarn and the single-covered yarn were interknitted at a ratio of 1:3 (the proportion of the single-covered yarn being 3/4). The results are shown in Fig. 6 in the same manner as the results of Example 3.

(Comparative Example 2)

An undergarment was prepared by following the procedure of Example 3, except that the silver-plated nylon yarn and the single-covered yarn were interknitted at a ratio of 1:4 (the proportion of the single-covered yarn being 4/5). The results are shown in Fig. 6 in the same manner as the results of Example 3.

The results obtained above reveal that the undergarment obtained in Example 3 (silver-plated nylon yarn: single-covered yarn=1:1) has an equivalent electromagnetic wave shielding capability but costs 30% less, as compared with the reference sample (silver-plated nylon yarn: single-covered yarn=1:0). Although the undergarment of Example 4 (silver-plated nylon yarn: single-covered yarn=1:2) has about 20% reduced electromagnetic wave shielding capability, this does not cause any problems in the case where moderate electromagnetic wave shielding capability is required. Further, the undergarment of Example 4 realizes remarkable cost reduction (50%). The undergarments of Comparative Examples 1 and 2 have substantially no electromagnetic wave shielding capability, although they attain cost reduction.

Therefore, the present invention provides an electromagnetic wave shielding knitted material and undergarment that do not cause unpleasant feeling when worn, or skin disorder due to metal allergy. The material and undergarment realize significant cost reduction because of reduction in conduct fiber amount, while maintaining the electromagnetic wave shielding capability.

The material and undergarment of the invention not only protect the human body from the influence of electromagnetic waves, but also effectively prevent electromagnetic waves from causing malfunction of a pacemaker or other medical devices implanted in the human body.

Table 2 shows the types of models and individual settings used in Example 5 and 6 and Comparative Example 3 to 5.

Table 2

| Type of model | Individual setting |
|---|---|
| Example 5 (short-sleeved, round-necked undershirt) | • Has a linear neck portion<br>• Covers the whole circumference of the torso |
| Example 6 (short-sleeved, V-necked undershirt) | • Neck depth: 80 mm<br>• Covers the whole circumference of the torso |

(continued)

| Type of model | Individual setting |
|---|---|
| Comparative Example 3 (short-sleeved collard shirt) | • Width of the front overlapping portion: 30 mm; Gap in the overlapping portion: 5 mm; Spaces between buttons (for fastening the right and left sides of the front at the centerline of the overlapping portion): 80 mm (the first button is at 10 mm below the upper edge of the shirt)<br>• Except for the gap in overlapping portion, covers the whole circumference of the torso |
| Comparative Example 4 (sleeveless vest) | • No overlapping portion in the right and left sides of the front (gap: 5 mm)<br>• Except for the gap, covers the whole circumference of the torso |
| Comparative Example 5 (without shielding garment) | |

(Example 5)

Used were a silver-plated nylon fiber yarn ("X-static" manufactured by SAUQUIT, 100 denier/34 filaments) as a conductive fiber yarn, an elastic fiber yarn (a single-covered yarn comprising a 20 d polyurethane thread as a stuffing thread covered with a 30 d nylon thread), and No. 80 count cotton yarn. These yarns are knitted to prepare a reversible plain knitted material which comprised a surface side made of the silver-plated nylon yarn and the single-covered yarn interknitted at a ratio of 1:1, and a back side (the side that would come into contact with the skin) made of the cotton yarn. The obtained material was cut and sewn in a routine manner to obtain a short-sleeved, round-necked undergarment. The undergarment had neck tapes and sleeve tapes made of the same knitted material and folded in such a manner that the cotton yarn layers of these tapes came to the side to be in contact with the skin. The tapes were sewn so that the silver-plated nylon-containing layers of these tapes came into contact with the surface side of the body of the undergarment.

The reversible plain knitted material was tested for electromagnetic wave shielding capability by the method (1) described above. The short-sleeved, round-necked undergarment was put on the dummy and then tested for electromagnetic wave shielding capability as a garment by the above method (2). Table 3 shows the test results. Fig. 8 shows the result of electromagnetic field distribution analysis of a model of the short-sleeved round-necked undergarment carried out by the above method (3).

Table 3

| | Electromagnetic wave shielding capability as a material | | Electromagnetic wave shielding capability as a garment | | |
|---|---|---|---|---|---|
| | | | Distance to the dummy | | |
| | Electric field shielding capability (dB) | Magnetic field shielding capability (dB) | 5 cm (dB) | 10 cm (dB) | 20 cm (dB) |
| Ex.5 | 44 | 23 | 22 | 23 | 28 |
| Ex.6 | | | 16 | 18 | 21 |
| Comp. Ex.3 | 37 | 16 | -1 | 1 | 8 |
| Comp. Ex.4 | 36 | 17 | -2 | -1 | 6 |

(Example 6)

Using the reversible plain knitted material obtained in Example 5, a short-sleeved, V-necked undergarment was prepared by following the procedure of Example 5 except that the shape of the neck was changed to V neck. The short-sleeved, V-necked undergarment was put on the dummy, and tested for electromagnetic wave shielding capability as a garment. Table 3 shows the test results. Fig. 9 shows the result of electromagnetic field distribution analysis of a model of the short-sleeved V-necked undergarment carried out by the above method (3).

(Comparative Example 3)

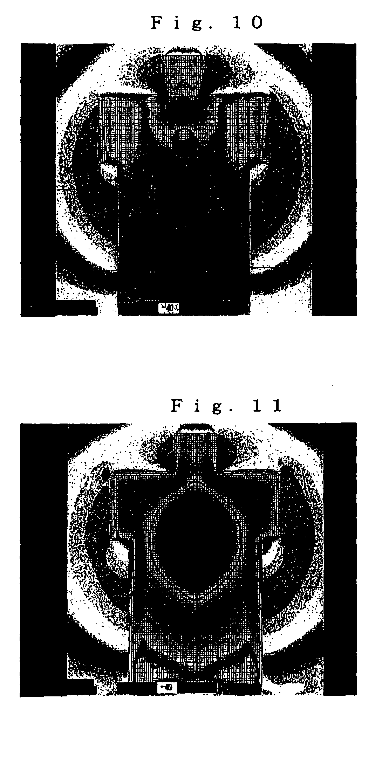

A collared shirt type electromagnetic wave shielding garment (a cardiac pacemaker protection garment against cellular telephone radiation, manufactured by MHP council) was used which was made of a plain weave fabric comprising, as the warp and weft, a conductive fiber yarn ("X-age" manufactured by Kanebo Spinning Corporation) containing a silver-plated nylon fiber ("X-static" manufactured by SAUQUIT). The weave fabric was tested for electromagnetic wave shielding capability as a material by the above method (1). The collard shirt type electromagnetic wave shielding garment was put on the dummy, and tested for electromagnetic wave shielding capability as a garment by the above method (2). Table 3 shows the results. Fig. 10 shows the result of electromagnetic field distribution analysis of a model of the collard shirt type electromagnetic wave shielding garment carried out by the above method (3).

(Comparative Example 4)

A vest type electromagnetic wave shielding garment ("MG Vest" manufactured by Freesia) comprising a mesh fabric comprising a silver-coated polyester fiber was used. The mesh fabric was tested for electromagnetic wave shielding capability as a material by the above method (1). The vest type electromagnetic wave shielding garment was put on the dummy and tested for electromagnetic wave shielding capability as a garment by the above method (2). Table 3 shows the test results. Fig. 11 shows the result of electromagnetic field distribution analysis of a model of the vest type electromagnetic wave shielding garment carried out by the above method (3).

(Comparative Example 5)

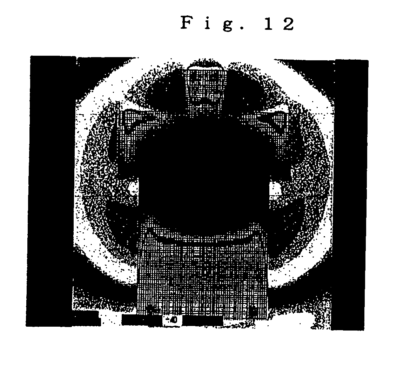

An electromagnetic field distribution analysis was carried out using the dummy without an electromagnetic wave shielding garment. Fig. 12 shows the result.

As is apparent from Table 3, the reversible plain knitted material obtained in Example 5 is similar (slightly superior) in electromagnetic wave shielding capability as a material, to the weave fabric of Comparative Example 3 and the mesh fabric of Comparative Example 4. On the other hand, the electromagnetic wave shielding capabilities as a garment achieved in Examples 5 and 6 are remarkably superior, demonstrating that the electromagnetic wave shielding garment of the present invention is properly designed and made by using the apparatus for measuring and evaluating electromagnetic wave shielding capability as a garment.

Further, in the FDTD electromagnetic field distribution analysis results (Figs. 8 to 12), the colors at the chest portions of the short-sleeved round-necked undergarment model of Example 5 (Fig. 8) and the short-sleeved V-necked undergarment model of Example 6 (Fig. 9) are green, yellow and orange, indicating that these models securely shield electromagnetic waves.

In contrast, the colors at the chest portions of the collared shirt type electromagnetic wave shielding garment model of Comparative Example 3 (Fig. 10) and the vest type electromagnetic wave shielding garment model of Comparative Example 4 (Fig. 11) are orange and red, which are approximately similar to the colors of the chest portion of the dummy without an electromagnetic wave shielding garment in Comparative Example 5 (Fig. 12). Thus, the garments of Comparative Examples have substantially no shielding effect against electromagnetic waves. These results agree well with the above measurement results of the electromagnetic field shielding capability as a garment.

As discussed above, the electromagnetic wave shielding garment according to the present invention prevents the influence on the human body of electromagnetic waves caused by high-frequency electromagnetic fields radiated from antennas of cellular telephones, radio equipment or like equipment placed in the vicinity of the human body. Further, the garment is capable of preventing electromagnetic waves from causing malfunction of medical devices implanted in the human body, such as pacemakers.

**Claims**

1.  A reversible electromagnetic wave shielding knitted material comprising a conductive fiber yarn (1) as a surface side and a natural fiber yarn (3) as a back side **characterized in that** it comprises, as the surface side, said conductive fiber yarn (1) and an elastic fiber yarn (2) interknitted with each other, wherein the proportion of the elastic fiber yarn (2) is greater than 0 but not greater than 2/3 of the total amount of the conductive fiber yarn (1) and the elastic fiber yarn (2) interknitted with each other.

2.  The material according to claim 1, which comprises a plain knitted structure or rib knitted structure obtained by plating the conductive fiber yarn (1) and the natural fiber yarn (3) in all the courses of the knitted material.

3. The material according to claim 1, wherein the conductive fiber yarn (1) is a multifilament in which each filament comprises a nylon fiber, a polyester fiber, an acrylic fiber, a polypropylene fiber or like synthetic fiber having a denier (d) of about 2 to about 8, and a metal component applied to a surface of the synthetic fiber by sputtering, vacuum deposition, electroless plating or like method.

4. The material according to claim 1, wherein the conductive fiber yarn (1) is a fiber of polyacetylene or like conductive resin, or a fine wire of gold, silver, copper, stainless steel or like metal.

5. The material according to claim 1, wherein the natural fiber yarn (3) comprises a natural fiber, a natural fiber/rayon fiber mixed spun yarn, or a natural fiber/synthetic fiber mixed spun yarn.

6. The material according to claim 1, wherein the conductive fiber yarn (1) is a silver-plated nylon yarn having a denier (d) of about 70 to about 210, and the natural fiber yarn (3) is a cotton yarn having a count of 30 to 150, the material having a KES hand value, i.e. G-soft, calculated according to the method on page 24, line 22 to page 25, line 24 of the description, of at least 6 and an electromagnetic wave shielding capability of at least 20 dB.

7. The material according to claim 1, wherein the elastic fiber yarn (2) is a single-covered yarn or a double-covered yarn comprising a polyurethane thread as a stuffing thread covered with a nylon thread.

8. The material according to claim 1, wherein the elastic fiber yarn (2) has a denier (d) of about 10 to about 200.

9. Use of the material according to claim 1 as an undergarment.

10. An electromagnetic wave shielding garment formed from the material of claim 1 for preventing electromagnetic waves from causing cardiac pacemaker malfunction.


**Patentansprüche**

1. Reversibles elektromagnetische Wellen abschirmendes gestricktes Material, umfassend ein leitfähiges Fasergarn (1) als eine Oberflächenseite und ein Naturfasergarn (3) als eine Rückseite, **dadurch gekennzeichnet, dass** es als die Oberflächenseite das leitfähige Fasergarn (1) und eine elastisches Fasergarn (2) umfasst, die miteinander verstrickt sind, wobei das Verhältnis des elastischen Fasergarns (2) größer als 0 aber nicht größer als 2/3 der Gesamtmenge des leitfähigen Fasergarns (1) und des elastischen Fasergarns (2), verstrickt miteinander, ist.

2. Material nach Anspruch 1, welches eine R/L-Strickstruktur oder eine R/R-Strickstruktur umfasst, erhalten durch das Plattieren des leitfähigen Fasergarns (1) und des Naturfasergarns (3) in allen Maschenreihen des gestrickten Materials.

3. Material nach Anspruch 1, wobei das leitfähige Fasergarn (1) ein Multifilament ist, in welchem jedes Filament eine Nylonfaser, eine Polyesterfaser, eine Acrylfaser, eine Polypropylenfaser oder eine ähnliche Synthetikfaser mit einem Denier (d) von etwa 2 bis etwa 8 und eine Metallkomponente umfasst, die auf einer Oberfläche der Synthetikfaser durch Sputtern, Vakuumaufdampfung, stromloses Abscheiden oder einem ähnlichen Verfahren aufgebracht ist.

4. Material nach Anspruch 1, wobei das leitfähige Fasergarn (1) eine Faser aus Polyacetylen oder ein ähnliches leitfähiges Harz oder ein feiner Draht aus Gold, Silber, Kupfer, Edelstahl oder einem ähnlichen Metall ist.

5. Material nach Anspruch 1, wobei das Naturfasergarn (3) eine Naturfaser, ein Naturfaser/Rayonfaser gemischtes Spinnfasergarn oder ein Naturfaser/Synthetikfaser gemischtes Spinnfasergarn umfasst.

6. Material nach Anspruch 1, wobei das leitfähige Fasergarn (1) ein silberplatiertes Nylongarn mit einem Denier (d) von etwa 70 bis etwa 120 ist und das Naturfasergarn (3) ein Baumwollgarn mit einer Fadendichte von 30 bis 150, wobei das Material einen KES Handwert, d.h. G-soft, berechnet nach dem Verfahren auf Seite 24, Zeile 22, bis Seite 25, Zeile 24, der Beschreibung, von mindestens 6 und eine elektromagnetische Wellen abschirmende Fähigkeit von mindestens 20 dB aufweist.

7. Material nach Anspruch 1, wobei das elastische Fasergarn (2) ein einzelnumsponnenes Garn oder ein doppelt-umsponnenes Garn, umfassend einen Polyurethanfaden als einen Stopffaden umsponnen mit einen Nylonfaden, ist.

**8.** Material nach Anspruch 1, wobei das elastische Fasergarn (2) ein Denier (d) von etwa 10 bis etwa 200 aufweist.

**9.** Verwendung des Materials nach Anspruch 1 als ein Unterkleid.

**10.** Elektromagnetische Wellen abschirmende Kleidung, hergestellt aus dem Material nach Anspruch 1, für das Hindern elektromagnetischer Wellen, eine Fehlfunktion eines Herzschrittmachers zu verursachen.


**Revendications**

**1.** Matière tricotée réversible de blindage contre les ondes électromagnétiques comprenant un fil en fibres conductrices (1) constituant une face avant et un fil en fibres naturelles (3) constituant une face arrière, **caractérisée en ce qu'**elle comprend, sur la face avant, ledit fil en fibres conductrices (1) et un fil en fibres élastiques (2) tricotés ensemble, la proportion du fil en fibres élastiques (2) étant plus grande que 0 mais pas plus grande que 2/3 de la quantité totale de fil en fibres conductrices (1) et de fil en fibres élastiques (2) tricotés ensemble.

**2.** Matière selon la revendication 1, qui comprend une structure tricotée simple ou une structure tricotée en côtes obtenue par placage du fil en fibres conductrices (1) et du fil en fibres naturelles (3) dans toutes les rangées de mailles de la matière tricotée.

**3.** Matière selon la revendication 1, dans laquelle le fil en fibres conductrices (1) est composé de multiples filaments qui comprennent chacun une fibre de nylon, une fibre polyester, une fibre acrylique, une fibre de polypropylène ou une fibre synthétique similaire ayant un denier (d) d'environ 2 à environ 8, et un composant métallique appliqué sur une surface de la fibre synthétique par pulvérisation cathodique, par dépôt par évaporation sous vide, par placage anélectrolytique ou par un procédé similaire.

**4.** Matière selon la revendication 1, dans laquelle le fil en fibres conductrices (1) est une fibre de polyacétylène ou de résine conductrice similaire, ou un fin fil d'or, d'argent, de cuivre, d'acier inoxydable ou d'un métal similaire.

**5.** Matière selon la revendication 1, dans laquelle le fil en fibres naturelles (3) comprend une fibre naturelle, une fibre naturelle ou une fibre de rayonne mélangée au filé, ou une fibre naturelle ou une fibre synthétique mélangée au filé.

**6.** Matière selon la revendication 1, dans laquelle le fil en fibres conductrices (1) est un fil de nylon à placage d'argent ayant un denier (d) d'environ 70 à environ 210, et le fil en fibres naturelles (3) est un fil de coton ayant un titre de 30 à 150, la matière ayant un indice de main KES, c'est-à-dire une valeur G-soft, calculée selon le procédé mentionné de la ligne 22 de la page 24 à la ligne 24 de la page 25 de la description, d'au moins 6 et une capacité de blindage d'onde électromagnétique d'au moins 20 dB.

**7.** Matière selon la revendication 1, dans laquelle le fil en fibres élastiques (2) est un fil simple recouvert ou un fil double recouvert comprenant un fil de polyuréthane en tant que fil de rembourrage recouvert d'un fil de nylon.

**8.** Matière selon la revendication 1, dans laquelle le fil en fibres élastiques (2) a un denier (d) d'environ 10 à environ 200.

**9.** Utilisation de la matière selon la revendication 1 en tant que sous-vêtement.

**10.** Un vêtement de blindage contre les ondes électromagnétiques formé à partir de la matière de la revendication 1 afin d'empêcher des ondes électromagnétiques de provoquer un dysfonctionnement d'un stimulateur cardiaque.

Fig. 1

Fig. 2

Fig. 3

Fig. 4

Fig. 5

F i g . 6

Ratio (silver-plated nylon yarn : single-covered yarn)

F i g . 7

Fig. 8

Fig. 9

EP 1 205 589 B1

Fig. 10

Fig. 11

18

Fig. 12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10168702 A
- JP 3010147 B
- JP 8176962 A
- JP 10292252 A
- JP 10077507 A
- JP 11050352 A
- JP 4054165 A

**Non-patent literature cited in the description**

- Standardization and Analysis of Evaluation of Hand. **Sueo Kawabata.** Journal of the Textile Machinery Society of Japan. 10 July 1980
- Science of Textile Consumption. Society of Science of Textile Consumption of Japan, 1999, vol. 40, 100-108